(19) Europäisches Patentamt
European Patent Office
Office européen des brevets

(11) Veröffentlichungsnummer : **0 425 441 B1**

# (12) EUROPÄISCHE PATENTSCHRIFT

(45) Veröffentlichungstag der Patentschrift : **27.12.95 Patentblatt 95/52**

(51) Int. Cl.[6] : **G03F 7/027,** G03C 9/08

(21) Anmeldenummer : **90810803.8**

(22) Anmeldetag : **19.10.90**

## (54) Photoempfindliches Gemisch

(30) Priorität : **27.10.89 CH 3902/89**
**23.03.90 CH 966/90**

(43) Veröffentlichungstag der Anmeldung : **02.05.91 Patentblatt 91/18**

(45) Bekanntmachung des Hinweises auf die Patenterteilung : **27.12.95 Patentblatt 95/52**

(84) Benannte Vertragsstaaten : **BE CH DE FR GB IT LI NL SE**

(56) Entgegenhaltungen :
**EP-A- 0 171 069**
**US-A- 4 789 620**

(73) Patentinhaber : **CIBA-GEIGY AG**
**Klybeckstrasse 141**
**CH-4002 Basel (CH)**

(72) Erfinder : **Hunziker, Max, Dr.**
**Chasseralstrasse 8**
**CH-3186 Düdingen (CH)**
Erfinder : **Hofmann, Manfred, Dr.**
**Route Bel-Air 38**
**CH-1723 Marly (CH)**
Erfinder : **Schulthess, Adrian, Dr.**
**Uf em Bärg**
**CH-1734 Tentlingen (CH)**
Erfinder : **Bernhard, Paul, Dr.**
**Rue Marcello 5**
**CH-1700 Fribourg (CH)**
Erfinder : **Klingert, Bernd, Dr.**
**Schloss-Strasse 17 C**
**W-7854 Inzlingen (DE)**
Erfinder : **Wiesendanger, Rolf, Dr.**
**Wilhelm His-Strasse 11**
**CH-4056 Basel (CH)**

EP 0 425 441 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die vorliegende Erfindung betrifft ein flüssiges, photoempfindliches Gemisch, ein Verfahren zum Polymerisieren dieses Gemisches mittels aktinischer Bestrahlung, ein Verfahren zur Herstellung von dreidimensionalen Gegenständen aus den flüssigen Gemischen sowie die Verwendung der erfindungsgemässen Gemische zur Herstellung von photopolymerisierten Schichten, insbesondere von dreidimensionalen Gegenständen, die aus mehreren photopolymerisierten Schichten aufgebaut sind.

Bekanntlich können strahlungsempfindliche, flüssige Harze oder Harzgemische vielseitig angewendet werden, beispielsweise als Beschichtungsmittel, Klebstoffe oder Photoresists. Im Prinzip sollten flüssige Harze oder Harzsysteme generell auch für die Herstellung von dreidimensionalen Gegenständen nach dem im US-Patent 4,575,330 beschriebenen stereolithographischen Verfahren geeignet sein, doch erweisen sich manche Harze als zu viskos, andere wiederum sind zu wenig lichtempfindlich oder unterliegen beim Härten einem zu grossen Schrumpfungsprozess. Auch lassen die Festigkeitseigenschaften der Formkörper bzw. Gegenstände aus photogehärteten Harzen oft zu wünschen übrig.

Mittels des stereolithographischen Verfahrens kann man bekanntlich komplizierte dreidimensionale Gegenstände aus flüssigen, lichtempfindlichen Harzen herstellen. Solche Gegenstände werden schichtweise aufgebaut,wobei jede neue härtbare Harzschicht durch Vorhärtung mittels UV/VIS-Licht mit der vorhergehenden vorgehärteten Schicht fest verbunden wird. Der Gesamtaufbau des dreidimensionalen Gegenstandes lässt sich bekanntlich nach einem computergesteuerten Prozess bewerkstelligen.

In den letzten Jahren hat es nicht an Anstrengungen gefehlt, Harzsysteme zu entwickeln, welche für das stereolithographische Verfahren einsetzbar sind. H. Kodama offenbart in Rev. Sci. Instrum. 52 (11) 1170-1173 (1981) unter dem Handelsnamen "Tevista" ein flüssiges, photohärtbares Harzgemisch, bestehend aus einem ungesättigten Polyester, Acrylsäureester, Styrol, einem Polymerisationsinitiator und einem Sensibilisator. Dieses Harzsystem ist für das stereolithographische Verfahren mit dem Nachteil behaftet, dass die Photoempfindlichkeit ungenügend ist und die sogenannte Grünfestigkeit (green strength) der mit Laserstrahlen vorgehärteten Gegenstände relativ niedrig ist.

Im US-Patent 4,575,330 wird das stereolithographische Verfahren näher beschrieben, wobei als flüssiges Harz ein modifiziertes Acrylat eingesetzt wird, das in der Beschreibung als "Potting Compound 363" bezeichnet wird. Solche Harzgemische werden im US-Patent 4,100,141 offenbart. Auch sie haben den Nachteil, dass sie ungenügend photoempfindlich sind und lange Zeiten für die Herstellung von dreidimensionalen Gegenständen nach dem stereolithographischen Verfahren benötigen.

Es ist daher verständlich, dass an Harze, die in stereolithographischen Verfahren eingesetzt werden sollen, hohe Anforderungen gestellt werden. Beispielsweise müssen sie hinsichtlich ihrer apparativen Verarbeitung eine geeignete Viskosität aufweisen. Die Photoempfindlichkeit des Harzsystems soll so beschaffen sein, dass das Verhältnis von aufgewendeter Strahlungsenergie und erzielter Eindringtiefe in das flüssige photoempfindliche Harzgemisch, wobei die betreffenden Teile sich verfestigen, im vertretbaren Rahmen liegt. Das heisst, bei einem für das stereolithographische Verfahren geeigneten Harz oder Harzgemisch soll mit wenig Strahlungsenergie eine möglichst hohe Härtungstiefe bei gleichzeitig hohem Polymerisationsgrad und guter Grünfestigkeit erreicht werden.

Beim Verfahren der aufeinanderfolgenden Polymerisation von dünnen Schichten, wie es im stereolithographischen Verfahren angewendet wird, ist gewöhnlich keine dieser Schichten völlig ausgehärtet. Der nicht völlig gehärtete Gegenstand wird als Grünling bezeichnet, und der Elastizitätsmodul und die Zugfestigkeit dieses Grünlings bezeichnet man auch als Grünfestigkeit. Normalerweise wird der Grünling dann mit UV/VIS-Licht gehärtet, beispielsweise mittels einer Quecksilber- oder Xenonbogenlampe. Die Grünfestigkeit eines Werkstückes stellt daher einen wichtigen Parameter dar, da Gegenstände mit einer geringen Grünfestigkeit unter ihrem eigenen Gewicht sich deformieren können oder sie können bei der Aushärtung sich durchbiegen oder absacken. Eine weitere Anforderung an Harzsysteme, die in stereolithographischen Verfahren eingesetzt werden sollen, ist ein möglichst kleiner Volumenschwund beim Uebergang vom flüssigen in den lasergehärteten Zustand. In der Technik der Stereolithographie wird als verfahrensspezifisches Mass für schwundinduzierte Deformationen der sogenannte "curl factor" angegeben. Ein curl factor von 1 besagt, dass keine schwundbedingten Deformationen auftreten. In der Praxis werden curl factors bis zu Werten von etwa 4 gemessen, jedoch sind nur Harze, die einen curl factor von 1-1,5 aufweisen, für ein stereolithographisches Verfahren geeignet.

Im US-Patent 4,789,620 werden photoempfindliche, Carboxylgruppen enthaltende Acrylatharzzusammensetzungen offenbart, die als Lötstopplacke Anwendung finden und aufgrund ihres Gehaltes an Carboxylgruppen in wässrigen Alkalilösungen löslich sind. Die aus diesen Harzzusammensetzungen hergestellten Formteile weisen den Nachteil einer erhöhten Feuchtigkeitsempfindlichkeit auf.

Es wurde nun gefunden, dass ein flüssiges, aus mehreren voneinander verschiedenen Mono- und Di(meth)acrylaten bestehendes Harzgemisch, das ausserdem ein Urethan(meth)acrylat und ein monomeres

oder oligomeres Di(meth)acrylat auf Basis von Bisphenol A oder Bisphenol F enthält, für das stereolithographische Verfahren eingesetzt werden kann und bei der Vorhärtung mittels Laserstrahlen Grünlinge ergibt, welche sich durch eine hohe Grünfestigkeit und einen tiefen curl factor auszeichnen. Die durch Aushärtung erhaltenen Gegenstände weisen gute mechanische Eigenschaften auf, sie sind hartelastisch und erlauben dadurch eine Nachbehandlung des Gegenstandes, wie Schleifen der Oberfläche, Einbau spezieller Bauelemente, wie beispielsweise Steckverbindungen, oder sogar eine spanabhebende Nachbearbeitung.

Gegenstand vorliegender Erfindung ist somit ein flüssiges, photoempfindliches Gemisch, enthaltend

a) 5-25 Gew.-% eines monomeren aliphatischen oder cycloaliphatischen Di(meth)acrylats mit einem Molekulargewicht (MG) von höchstens 800,

b) 0-15 Gew.-% eines monomeren Poly(meth)acrylats mit einer Funktionalität von mindestens 3 und einem MG von höchstens 600,

c) 0-20 Gew.-% eines Mono(meth)acrylats oder einer Mono-N-vinylverbindung mit einem MG von höchstens 500,

d) 20-60 Gew.-% eines Urethan(meth)acrylats mit einer Funktionalität von 2 bis 4 und einem MG von 500 bis 1000,

e) 10-50 Gew.-% eines monomeren oder oligomeren Di(meth)acrylats auf Basis von Bisphenol A oder Bisphenol F,

f) 0,1-10 Gew.-% eines Photoinitiators und

g) 0-5 Gew.-% üblicher Additive,

wobei der Anteil der Komponenten a) bis g) zusammen 100 Gew.-% beträgt.

Vorzugsweise enthält das erfindungsgemässe Gemisch

a) 5-15 Gew.-% eines monomeren aliphatischen oder cycloaliphatischen Di(meth)acrylats,

b) 5-10 Gew.-% eines monomeren Poly(meth)acrylats,

c) 1-15 Gew.-% eines Mono(meth)acrylats,

d) 30-50 Gew.-% eines Urethan(meth)acrylats,

e) 30-50 Gew.-% eines Di(meth)acrylats auf Basis von Bisphenol A oder Bisphenol F,

f) 0,5-7 Gew.-% eines Photoinitiators und

g) 0,01-3 Gew.-% eines Additivs.

Als Verbindungen der Komponente (a) eignen sich beispielsweise die Diacrylat- und Dimethacrylatester von aliphatischen oder cycloaliphatischen Diolen, wie 1,3-Butylenglykol, 1,4-Butandiol, Neopentylglykol, 1,6-Hexandiol, Diethylenglykol, Triethylenglykol, Tetraethylenglykol, Polyethylenglykol-400, Polyethylenglykol-600, Tripropylenglykol, ethoxyliertes oder propoxyliertes Neopentylglykol, 1,4-Dihydroxymethylcyclohexan, 2,2-Bis-(4-hydroxycyclohexyl)-propan oder Bis-(4-hydroxycyclohexyl)-methan.

Vorzugsweise verwendet man als Verbindung der Komponente (a) aliphatische Di(meth)-acrylate, insbesondere solche mit einem MG von 200 bis 500.

Als Verbindungen der Komponente (b) eignen sich beispielsweise Tri-, Tetra- und Pentaacrylate oder -methacrylate der Formeln I, II und III

$$R^1\text{-}CH_2\text{-}C(CH_2\text{-}R^2)_3 \qquad (I),$$

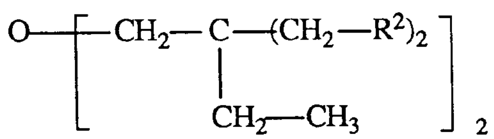

(II)

und

$$R^2\text{-}CH(CH_2\text{-}R^2)_2 \qquad (III),$$

worin $R^1$ ein Wasserstoffatom, Methyl, Hydroxyl oder einen Rest der Formel IV

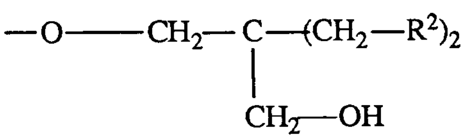

(IV)

bedeutet und $R^2$ einen Rest der Formel V

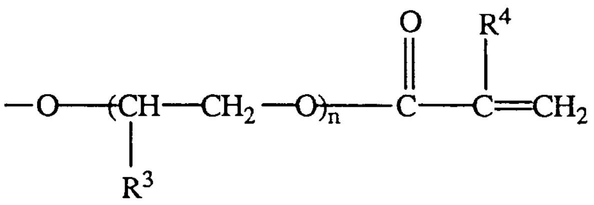 (V)

bedeutet, worin n für Null oder eine Zahl von 1-3 steht und $R^3$ und $R^4$ unabhängig voneinander je ein Wasserstoffatom oder Methyl bedeuten.

Von den Verbindungen der Formeln I bis III sind solche der Formel I, worin $R^1$ eine Methylgruppe oder einen Rest der Formel IV darstellt und $R^2$ einen Rest der Formel V bedeutet, worin n Null ist, besonders bevorzugt.

Als Verbindungen der Komponente (b) können beispielsweise eingesetzt werden: 1,1,1-Trimethylolpropantriacrylat oder -methacrylat, ethoxyliertes 1,1,1-Trimethylolpropantriacrylat oder -methacrylat, Pentaerythritoltetraacrylat, Pentaerythritolmonohydroxytriacrylat oder -methacrylat,Dipentaerythritolmonohydroxypentaacrylat oder -methacrylat. Solche Verbindungen sind bekannt und zum Teil im Handel erhältlich, beispielsweise von der Firma SARTOMER Company unter der Produktbezeichnung SR-295, SR-350, SR-351, SR-367, SR-399, SR-444 und SR-454.

Insbesondere weisen die Verbindungen der Komponente (b) ein MG von 250 bis 500 auf.

In den erfindungsgemässen Gemischen können als Komponente (c) beispielsweise folgende Verbindungen enthalten sein: Allylacrylat, Allylmethacrylat, Methyl-, Ethyl-, n-Propyl-, n-Butyl-, Isobutyl-, n-Hexyl-, 2-Ethylhexyl-, n-Octyl-, n-Decyl- und n-Dodecylacrylat und -methacrylat, 2-Hydroxyethyl-, 2- und 3-Hydroxypropylacrylat und -methacrylat, 2-Methoxyethyl-, 2-Ethoxyethyl- und 2- oder 3-Ethoxypropylacrylat, Tetrahydrofurfurylmethacrylat, 2-(2-Ethoxyethoxy)ethylacrylat, Cyclohexylmethacrylat, 2-Phenoxyethylacrylat, Glycidylacrylat und Isodecylacrylat sowie als Mono-N-vinylverbindung N-Vinylpyrrolidon oder N-Vinylcaprolactam. Solche Produkte sind ebenfalls bekannt und zum Teil im Handel erhältlich, zum Beispiel von der Firma SARTOMER Company.

Vorzugsweise weisen die Verbindungen der Komponente (c) ein MG von 50-300 auf.

Die in den erfindungsgemässen Gemischen als Komponente (d) verwendeten Urethanacrylate sind dem Fachmann bekannt und können in bekannter Weise hergestellt werden, indem man beispielsweise ein hydroxylterminiertes Polyurethan mit Acrylsäure oder Methacrylsäure zu dem entsprechenden Urethanacrylat umsetzt, oder indem man ein siocyanatterminiertes Präpolymer mit Hydroxyalkylacrylaten oder -methacrylaten zum Urethanacrylat umsetzt. Entsprechende Verfahren werden beispielsweise in den publizierten EP-Patentanmeldungen 114982 und 133908 offenbart. Das Molekulargewicht solcher Acrylate liegt im allgemeinen im Bereich von 400 bis 10000, vorzugsweise zwischen 500 bis 7000.

Urethanacrylate sind auch im Handel erhältlich und werden beispielsweise unter der Bezeichnung EBECRYL® von der Firmal UCB, unter der Bezeichnung Uvithane® von der Firma Morton Thiokol oder unter den Produktebezeichnungen SR 9504, SR 9600, SR 9610, SR 9620, SR 9630, SR 9640 und SR 9650 von der Firma SARTOMER Company angeboten.

Bevorzugt werden als Urethanacrylate solche eingesetzt, die sich ein MG von 500-7000 aufweisen und aus aliphatischen Edukten hergestellt worden sind.

Als Komponente (e) können als Diacrylate auf Basis von Bisphenol A und Bisphenol F sowohl die Bisphenol A- und Bisphenol F-diacrylate und -dimethacrylate als auch die Diacrylate oder Dimethacrylate von alkoxylierten, vorzugsweise ethoxyliertem oder propoxyliertem Bisphenol A oder F eingesetzt werden. Ferner sind auch die durch Umsetzung von Bisphenol-A- oder Bisphenol F-diglycidylether mit (Meth)acrylsäure erhältlichen Acrylate geeignet. Solche monomeren oder oligomeren Di(meth)acrylate sind ebenfalls bekannt und zum Teil im Handel erhältlich, beispielsweise unter der Produktbezeichnung SR-348 für ethoxyliertes Bisphenol A-dimethacrylat und unter der Produktbezeichnung SR-349 für ethoxyliertes Bisphenol A-diacrylat von der Firma SARTOMER Company. Vorzugsweise verwendet man als Komponente (e) die Di(meth)acrylate von Bisphenol A oder F und von ethoxyliertem Bisphenol A oder ethoxyliertem Bisphenol F.

Insbesondere weisen die Verbindungen der Komponente (e) ein MG von 300-1000 auf.

In den erfindungsgemässen Gemischen können alle Typen von Photoinitiatoren als Komponente (f) eingesetzt werden, welche bei der entsprechenden Bestrahlung freie Radikale bilden. Typische Verbindungen bekannter Photoinitiatoren sind Benzoine, Benzoinether, wie Benzoin, Benzoinmethylether, Benzoinethylether und Benzoinisopropylether, Benzoinphenylether und Benzoinacetat, Acetphenone, wie Acetophenon, 2,2-Dimethoxyacetophenon, und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert.-Butylanthrachinon, 1-Choranthrachinon und 2-Amylanthrachinon, Triphenylphosphin, Benzoylphosphinoxide, wie beispielsweise 2,4,6-Trimethylbenzoyldiphenylphosphinoxid (Luzirin TPO), Benzophenone, wie Benzophenon und 4,4′-Bis-(N,N′-dimethylamino)-benzophenon, Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton, welche alle bekannte Verbindungen darstellen.

Besonders geeignete Photoinitiatoren, welche gewöhnlich in Kombination mit einem HeCd-Laser als Strahlenquelle verwendet werden, sind Acetophenone, wie 2,2-Dialkoxybenzophenone und $\alpha$-Hydroxyphenylketone, beispielsweise 1-Hydroxycyclohexylphenylketon oder (2-Hydroxyisopropyl)-phenylketon (=2-Hydroxy-2,2-dimethylacetophenon).

Eine andere Klasse von Photoinitiatoren (f), die gewöhnlich bei Verwendung von Argonion-Lasern eingesetzt wird, sind die Benzilketale, wie beispielsweise Benzildimethylketal. Insbesondere verwendet man als Photoinitiator ein $\alpha$-Hydroxyphenylketon, Benzildimethylketal oder 2,4,6-Trimethylbenzoyldiphenylphosphinoxid.

Eine weitere Klasse von geeigneten Photoinitiatoren (f) stellen die ionischen Farbstoff-Gegenionverbindungen (ionic dye-counter ion compound) dar, welche in der Lage sind, aktinische Strahlen zu absorbieren und freie Radikale zu erzeugen, die die Polymerisation der Acrylate a) bis e) oder der Mono-N-vinylverbindung c) initiieren. Die erfindungsgemässen Gemische, welche ionische Farbstoff-Gegenionverbindungen enthalten, können auf diese Weise mit sichtbarem Licht im einstellbaren Wellenlängenbereich von 400-700 nm variabler gehärtet werden. Ionische Farbstoff-Gegenionverbindungen und deren Wirkungsweise sind bekannt, beispielsweise aus der EP-A-O 223 587 und den US-Patenten 4,751,102; 4,772,530 und 4,72,541. Als Beispiele für geeignete ionische Farbstoff-Gegenionverbindungen seien genannt die anionischen Farbstoff-Jodoniumionkomplexe, die anionischen Farbstoff-Pyrylliumionkomplexe und insbesondere die kationischen Farbstoff-Boratanionverbindungen der Formel VI

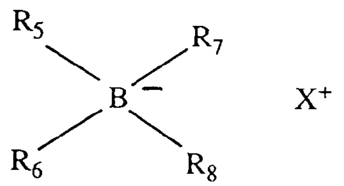

(VI),

worin $X^+$ für einen kationischen Farbstoff steht und $R_5$, $R_6$, $R_7$ und $R_8$ unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten.

Die Photoinitiatoren werden bekanntlich in wirksamen Mengen zugesetzt, das heisst, in Mengen von etwa 0,1 bis etwa 10 Gewichtsprozent, bezogen auf die Gesamtmenge des Gemisches. Wenn die erfindungsgemässen Gemische für stereolithographiste Verfahren verwendet werden, wobei normalerweise Laserstrahlen eingesetzt werden, ist es wesentlich, dass die Absorptionsfähigkeit der Gemische durch Typ und Konzentration des Photoinitiators so abgestimmt wird, dass die Härtungstiefe bei normaler Lasergeschwindigkeit ungefähr 0,1 bis 2,5 mm beträgt.

Die erfindungsgemässen Gemische können auch verschiedene Photoinitiatoren enthalten, welche gegenüber Strahlen von Emissionslinien unterschiedlicher Wellenlängen verschieden strahlungsempfindlich sind. Man erreicht dadurch beispielsweise eine bessere Ausnützung einer UV/VIS-Lichtquelle, welche Emissionslinien unterschiedlicher Wellenlänge ausstrahlt. Vorteilhaft ist es dabei, wenn die verschiedenen Photoinitiatoren so ausgewählt und in einer solchen Konzentration eingesetzt werden, dass bei den verwendeten Emissionslinien eine gleiche optische Absorption erzeugt wird.

Falls erwünscht können den erfindungsgemässen Gemischen die üblichen Additive zugesetzt werden, beispielsweise Stabilisatoren, wie UV-Stabilisatoren, Polymerisationsinhibitoren, Trennmittel, Benetzungsmittel, Verlaufsmittel, Sensibilisatoren, Antiabsetzmittel, oberflächenaktive Mittel, Farbstoffe, Pigmente oder Füllstoffe.

Die erfindungsgemässen Gemische können in bekannter Weise hergestellt werden, beispielsweise durch Vormischen einzelner Komponenten und anschliessendes Vermischen dieser Vormischungen oder durch Vermischen aller Komponenten mittels üblicher Vorrichtungen, wie Rührbehälter, in Abwesenheit von Licht und gegebenenfalls bei leicht erhöhter Temperatur.

Die erfindungsgemässen, photoempfindlichen Gemische können durch Bestrahlen mit aktinischem Licht, beispielsweise mittels Elektronen-, Röntgenstrahlen, UV- oder VIS-Licht, das heisst, mit Strahlen im Wellenlängenbereich von 280-650 nm polymerisiert werden. Besonders geeignet sind Laserstrahlen von HeCd, Argon oder Stickstoff sowie Metalldampf und NdYAG-Laser mit vervielfachter Frequenz. Es ist dem Fachmann bekannt, dass für jede gewählte Lichtquelle der geeignete Photoinitiator ausgewählt und gegebenenfalls sensibilisiert werden muss. Man hat erkannt, dass die Eindringtiefe der Strahlen in die zu polymerisierende Zusammensetzung und die Arbeitsgeschwindigkeit in direktem Zusammenhang mit dem Absorptionskoeffizienten und der Konzentration des Photoinitiators stehen. In der Stereolithographie werden vorzugsweise solche Photoinitiatoren eingesetzt, welche die höchste Anzahl von entstehenden freien Radikalen bewirken und die grösste Strahlungseindringtiefe in die zu polymerisierenden Zusammensetzungen ermöglichen.

Gegenstand der Erfindung ist somit auch ein Verfahren zum Polymerisieren der erfindungsgemässen Gemische, indem man diese mit aktinischem Licht bestrahlt.

Die erfindungsgemässen Gemische sind Flüssigkeiten mit einer Viskosität von etwa 300 bis etwa 10000 mPa·s bei 30°C, vorzugsweise von 500 bis 5000 mPa·s, insbesondere von 500 bis 2500 mPa·s. Die erfindungsgemässen Gemische weisen bei hoher Lichtempfindlichkeit überraschenderweise einen niedrigen Schrumpfungsfaktor (curl factor) und eine hohe Formfestigkeit nach der Vorhärtung mittels Laserstrahlen (green strength) auf, was besonders bei stereolithographischen Verfahren wichtig ist. Nach der vollständigen Aushärtung weisen die aus den erfindungsgemässen Gemischen hergestellten Formkörper eine hohe Festigkeit, bei ausreichender Elastizität aus, sie sind also hartelastisch.

Ein weiterer Erfindungsgegenstand ist auch ein Verfahren zur Herstellung von dreidimensionalen Gegenständen aus den flüssigen, erfindungsgemässen Gemischen mittels stereolithographischen Verfahren, wobei die Oberfläche einer Schicht aus dem erfindungsgemässen, flüssigen Gemisch ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

Bei diesem Verfahren wird als Strahlungsquelle vorzugsweise ein Laserstrahl verwendet, der vorzugsweise computergesteuert ist.

Werden die erfindungsgemässen Gemische als Beschichtungsmittel eingesetzt, so erhält man klare und harte Beschichtungen auf Holz, Papier, Metall, Keramik oder anderen Oberflächen. Die Beschichtungsdicke kann dabei sehr variieren und etwa von 1 µm bis etwa 1 mm betragen. Aus den erfindungsgemässen Gemischen können Reliefbilder für gedruckte Schaltungen oder Druckplatten direkt durch Bestrahlen der Gemische hergestellt werden, beispielsweise mittels eines computergesteuerten Laserstrahls geeigneter Wellenlänge oder unter Anwendung einer Photomaske und einer entsprechenden Lichtquelle.

Vorzugsweise verwendet man die erfindungsgemässen Gemische zur Herstellung von photopolymerisierten Schichten, insbesondere in Form von dreidimensionalen Gegenständen, die aus mehreren aneinander haftenden, verfestigten Schichten aufgebaut sind.

Der curl factor wird an stereolithographisch hergestellten Prüfkörpern ermittelt, wobei die Deformation eines freitragenden Teils des Prüfkörpers durch Schrumpfung ermittelt wird. Der curl factor ist das Verhältnis aus der Höhe eines deformierten fixierten Teilstückes des Prüfkörpers zur Höhe des nichtdeformierten Teilstückes. Die Verhältniszahl 1 bedeutet somit, dass keine Schrumpfung aufgetreten ist, und Werte bis 1,5 stellen akzeptierbare Eigenschaften hinsichtlich Schrumpfung und Deformation dar.

Die mechanischen Eigenschaften des mittels Laserstrahlen gehärteten Gegenstandes (green strength) und des durch Nachhärtung erhaltenen Gegenstandes werden an der Zugtestmaschine Instron® 1112 gemessen, wobei 45,7 mm lange Stränge mit Querschnitt 0,38 x 0,51 mm als Testkörper verwendet wurden.

<u>Beispiel 1:</u> 39,75 g ethoxyliertes Bisphenol A-diacrylat (MG = 424, Produkt SR-349 der Firma SARTOMER Company) werden bei 40°C mit 40,02 g Urethanacrylat (MG = 1700, Produkt SR 9504 der Firma SARTOMER Company), 3,25 g 1,1,1-Trimethylolpropantriacrylat (MG = 408), 12,99 g 1,4-Butandioldiacrylat (MG = 198) und 4 g 1-Hydroxycyclohexylphenylketon vermischt. Die resultierende homogene flüssige Mischung weist eine Viskosität von 1510 mPa·s bei 30°C auf. Der curl factor eines aus individuellen Schichten (Schichtdicke = 0,305 mm) aufgebauten dreidimensionalen Formkörpers, hergestellt mit einem HeCd-Laser, beträgt 1,05. Der sogenannte grüne, mit Laserstrahlen gehärtete Formkörper, weist einen Elastizitätsmodul (green strength) von 20 $N/mm^2$, eine Zugfestigkeit von 2,4 $N/mm^2$ und eine Bruchdehnung von 13 % auf. Nach der Aushärtung des grünen Formkörpers während 30 Minuten unter UV/VIS-Licht mittels einer Hg-Lampe beträgt der Elastizitätsmodul 1500 $N/mm^2$, weist die Zugfestigkeit den Wert von 40 $N/mm^2$ auf und beträgt die Bruchdehnung 7 bis 19 %.

<u>Beispiele 2-7:</u> Es werden wie in Beispiel 1 Gemische durch Vermischen der in der folgenden Tabelle 1 angegebenen Komponenten hergestellt und zu dreidimensionalen Formkörpern unter den in Beispiel 1 angegebenen Bedingungen verarbeit. Die Eigenschaften der erhaltenen Formkörper sind ebenfalls in Tabelle 1 angegeben.

Tabelle 1:

| Beispiel | 2 | 3 | 4 | 5 | 6 | 7 |
|---|---|---|---|---|---|---|
| Pentaerythritoltetraacrylat (MG = 352; SR-295) [g] | 3,60 | 2,88 | 3,61 | 2,89 | - | - |
| Trimethylolpropantriacrylat (MG = 296; SR-351) [g] | - | - | - | - | 4,06 | 3,25 |
| 1,4-Butandioldiacrylat (MG = 198; SR-213 [g] | 12,15 | 12,97 | - | - | 12,17 | 12,99 |
| Diethylenglykoldiacrylat (MG = 214; SR-230) [g] | - | - | 13,18 | 14,07 | - | - |
| Urethanacrylat (MG = 1700; SR-9504) [g] | 40,50 | 40,40 | 39,45 | 39,28 | 40,02 | 40,02 |
| Ethoxyliertes Bisphenol A-diacrylat (MG = 424; SR-349) [g] | 39,75 | 39,75 | 39,75 | 39,75 | 39,75 | 39,75 |
| 1-Hydroxycyclohexylphenylketon [g] | 4,00 | 4,00 | 4,00 | 4,00 | 4,00 | 4,00 |
| Viskosität bei 30°C [mPa · s] | 1720 | 1650 | 1870 | 1750 | 1650 | 1510 |
| Mechanische Eigenschaften nach der Laser-Härtung: | | | | | | |
| Elastizitätsmodul [N/mm²] | 30 | 25 | 50 | 50 | 15 | 18 |
| Zugfestigkeit [N/mm²] | 3,5 | 3,3 | 7,3 | 7,3 | 2,8 | 2,4 |
| Bruchdehnung [%] | 14 | 12 | 15 | 15 | 12 | 13 |
| curl factor | ~ 1,0 | x) | 1,01 | x) | ~ 1,0 | x) |
| Mechanische Eigenschaften nach der UV/VIS-Härtung: | | | | | | |
| Elastizitätsmodul [N/mm²] | 1500 | 1500 | 1700 | 1400 | 1400 | 1400 |
| Zugfestigkeit [N/mm²] | 55 | 50 | 50 | 35 | 40 | 40 |
| Bruchdehnung [%] | 10-15 | 10-15 | 14-20 | 10-22 | 5-15 | 5-10 |

x) nicht gemessen

Beispiele 8-13: Es werden wie in Beispiel 1 Gemische durch Vermischen der in der folgenden Tabelle 2 angegebenen Komponenten hergestellt und zu dreidimensionalen Formkörpern unter den im Beispiel 1 angegebenen Bedingungen verarbeitet. Die Eigenschaften der erhaltenen Formkörper sind ebenfalls in Tabelle 2 angegeben.

Tabelle 2:

| Beispiel | 8 | 9 | 10 | 11 | 12 | 13 |
|---|---|---|---|---|---|---|
| Pentaerythritoltetraacrylat (MG = 352; SR-295) [g] | 5,89 | 5,43 | 3,76 | 3,64 | 6,04 | 3,92 |
| 1,4-Butandioldiacrylat (MG = 198; SR-213 [g] | 9,94 | 9,16 | 12,68 | 12,27 | 10,19 | 6,61 |
| Ethoxyliertes Bisphenol A-diacrylat (MG = 424; SR-349) [g] | 39,75 | 39,75 | 39,75 | 39,75 | 39,75 | 39,75 |
| 1-Hydroxycyclohexylphenylketon [g] | 4,00 | 4,00 | 4,00 | 4,00 | 4,00 | 4,00 |
| SR-9503 | 40,42 | | | | | |
| SR-9505 | | 41,66 | | | | |
| U-782 | | | 39,81 | | | |
| U-892 | | | | 40,34 | | |
| PM-6162 | | | | | 40,03 | |
| PM6184 | | | | | | 45,72 |
| Viskosität bei 30°C [mPa · s] | 4600 | 5400 | 6700 | 3400 | 3000 | 6450 |
| Mechanische Eigenschaften nach der Laser-Härtung: | | | | | | |
| Elastizitätsmodul [N/mm$^2$] | 20 | 43 | 9 | 14 | 9 | 58 |
| Zugfestigkeit [N/mm$^2$] | 5 | 6 | 2 | 4 | 2 | 8 |
| Bruchdehnung [%] | 50 | 33 | 33 | 38 | 28 | 43 |
| Mechanische Eigenschaften nach der UV/VIS-Härtung: | | | | | | |
| Elastizitätsmodul [N/mm$^2$] | 340 | 560 | 215 | 270 | 196 | 625 |
| Zugfestigkeit [N/mm$^2$] | 41 | 55 | 32 | 32 | 22 | 57 |
| Bruchdehnung [%] | 46 | 16 | 41 | 37 | 19 | 15 |

SR-9503: Lineares Urethanacrylat der Firma SARTOMER; MG = 2000, Viskosität = 2000 Pa·s bei 21°C.

SR-9505: Urethanacrylat der Firma SARTOMER; MG = 1250, Viskosität: 145 Pa·s bei 38°C.

U-782: Uvithane 782, Urethanacrylat der Firma Morton Thiokol Inc., Doppelbindungsäquivalent = 2400, Viskosität = 800-1600 Pa·s bei 49°C.

U-892: Uvithane 892, Urethanacrylat der Firma Morton Thiokol Inc., Doppelbindungsäquivalent = 1800, Viskosität 410 Pa·s bei 49°C.

PM-6162: Photomer 6162, lineares Urethanacrylat der Firma Lankro, MG = 5000.

PM-6184: Photomer 6184, trifunktionelles Urethanacrylat der Firma Lankro, MG = 1800.

Beispiele 14-25: Es werden wie in Beispiel 1 Gemische durch Vermischen der in der folgenden Tabelle 3 angegebenen Kompoenenten hergestellt und zu dreidimensionalen Formkörpern unter den im Beispiel 1 angegebenen Bedingungen verarbeitet. Die Eigenschaften der erhaltenen Formkörper sind ebenfalls in Tabelle 3 angegeben.

Tabelle 3:

| Beispiele | 14 | 15 | 16 | 17 | 18 | 19 | 20 | 21 | 22 | 23 | 24 | 25 |
|---|---|---|---|---|---|---|---|---|---|---|---|---|
| SC-961 | | | | | | | | | | | 39,47 | 39 |
| SC-964 | 39,47 | 39,47 | 39,47 | 39,47 | | | | | | | | |
| SC-965 | | | | | | | | | | 39,47 | | |
| SC-9504 | | | | | 39,47 | 39,47 | 39,47 | 39,47 | 39,47 | | | |
| N-Vinylpyrrolidon | | 5 | 5 | 5 | | 5 | 5 | 5 | | | | 2 |
| LR-8765 | 10,71 | 10,71 | | 10,71 | 10,71 | 10,71 | | 10,71 | 10,71 | 10,71 | 10,71 | 11 |
| CL-959 | 10,36 | 5,36 | 5,36 | 5,36 | 10,36 | 5,36 | 5,36 | 5,36 | 5,36 | 10,36 | 10,36 | 8 |
| SR-209 | | | 10,71 | | | | 10,71 | | | | | |
| SR-348 | | | | 34,26 | | | | 34,26 | | | | 33 |
| SR-349 | 34,26 | 34,26 | 34,26 | | 34,26 | 34,26 | 34,26 | | 39,26 | 34,26 | 34,26 | |
| 1-Hydroxycyclohexyl-phenylketon | 5 | 5 | 5 | 5 | 5 | 5 | 5 | 5 | 5 | 5 | 5 | 5 |
| Viscosität bei 35°C [mPa·s] | 2870 | 2020 | 1040 | 1920 | 2500 | 1700 | 1040 | 1600 | 2960 | 2810 | 2810 | 3410 |
| Mechanische Eigenschaften nach der Laser-Härtung: | | | | | | | | | | | | |
| Elastizitätsmodul bei 80 mJ/cm$^2$ [N/mm$^2$] | 75 | 136 | 3 | 112 | 57 | 73 | 1 | 110 | 187 | 66 | 189 | 55 |
| Zugfestigkeit [N/mm$^2$] | 6 | 9 | 3 | 8 | 6 | 6 | 1 | 8 | 6 | 5 | 6 | 5 |
| Bruchdehnung [%] | 27 | 27 | 20 | 31 | 22 | 23 | 31 | 38 | 19 | 22 | 28 | 23 |

Tabelle 3 (Fortsetzung):

| Beispiele | 14 | 15 | 16 | 17 | 18 | 19 | 20 | 21 | 22 | 23 | 24 | 25 |
|---|---|---|---|---|---|---|---|---|---|---|---|---|
| <u>Mechanische Eigenschaften nach der UV/VIS Härtung:</u> | | | | | | | | | | | | |
| Elastizitätsmodul [N/mm$^2$] | 599 | 657 | 959 | 673 | 412 | 596 | 887 | 571 | 526 | 501 | 435 | 826 |
| Zugfestigkeit [N/mm$^2$] | 22 | 22 | 26 | 23 | 21 | 23 | 24 | 27 | 21 | 20 | 19 | 22 |
| Bruchdehnung [%] | 27 | 25 | 22 | 28 | 28 | 26 | 16 | 48 | 24 | 25 | 26 | 14 |

SC-961: Aliphatisches Urethandiacrylat der Firma SARTOMER; MG = 1850, Viskosität = 81 Pa·s bei 60°C.

SC-964: Aliphatisches Urethandiacrylat der Firma SARTOMER; MG = 1300, Viskosität = 21 Pa·s bei 60°C.

SC-965: Aliphatisches Urethandiacrylat der Firma SARTOMER; MG = 1500, Viskosität = 12 Pa·s bei 60°C.

SR-9504: Aliphatisches Urethandiacrylat der Firma SARTOMER; MG = 1700, Viskosität = 167 Pa·s bei 21°C.

LR-8765: Diacrylat des Butandioldiglycidylethers der Firma BASF; MG = 346.

CL-959: Monofunktionelles Acrylat der Firma SNPE; MG = 185.

SR-209: Tetraethylenglykoldimethacrylat der Firma SARTOMER; MG = 330.

SR-348: Ethoxyliertes Biophenol A-dimethacrylat der Firma SARTOMER; MG = 452.

SR-349: Ethoxyliertes Biophenol A-diacrylat der Firma SARTOMER; MG = 424.

## Patentansprüche

1. Flüssiges, photoempfindliches Gemisch, enthaltend
   a) 5-25 Gew.-% eines monomeren aliphatischen oder cycloaliphatischen Di(meth)acrylats mit einem Molekulargewicht (MG) von höchstens 800,
   b) 0-15 Gew.-% eines monomeren Poly(meth)acrylats mit einer Funktionalität von mindestens 3 und einem MG von höchstens 600,
   c) 0-20 Gew.-% eines Mono(meth)acrylats oder einer Mono-N-vinylverbindung mit einem MG von höchstens 500,
   d) 20-60 Gew.-% eines Urethan(meth)acrylats mit einer Funktionalität von 2 bis 4 und einem MG von 500 bis 10000,
   e) 10-50 Gew.-% eines monomeren oder oligomeren Di(meth)acrylats auf Basis von Bisphenol A oder Bisphenol F,
   f) 0,1-10 Gew.-% eines Photoinitiators und
   g) 0-5 Gew.-% üblicher Additive,

   wobei der Anteil der Komponenten a) bis g) zusammen 100 Gew.-% beträgt.

2. Gemisch gemäss Anspruch 1, enthaltend
   a) 5-15 Gew.-% eines monomeren aliphatischen oder cycloaliphatischen Di(meth)acrylats,
   b) 5-10 Gew.-% eines monomeren Poly(meth)acrylats,
   c) 1-15 Gew.-% eines Mono(meth)acrylats,
   d) 30-50 Gew.-% eines Urethan(meth)acrylats,
   e) 30-50 Gew.-% eines Di(meth)acrylats auf Basis von Bisphenol A oder Bisphenol F,
   f) 0,5-7 Gew.-% eines Photoinitiators und
   g) 0,01-3 Gew.-% eines Additivs.

3. Gemisch gemäss Anspruch 1, worin das MG der Komponente (a) 200-500, der Komponente (b) 250-500, der Komponente (c) 50-300, der Komponente (d) 500-7000 und der Komponente (e) 300-1000 beträgt.

4. Gemisch gemäss Anspruch 1, enthaltend als Komponente (a) aliphatische Di(meth)acrylate.

5. Gemisch gemäss Anspruch 1, enthaltend als Komponente (b) ein Tri-, Tetra- oder Pentaacrylat oder -methacrylat der Formel I, II oder III

$R^1\text{-}CH_2\text{-}C\text{-}(CH_2\text{-}R^2)_3$ (I),

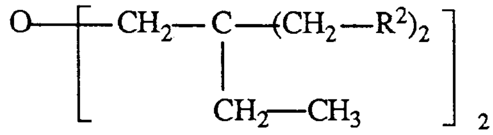

(II)

oder

$R^2\text{-}CH\text{-}(CH_2\text{-}R^2)_2$ (III),

worin $R^1$ ein Wasserstoffatom, Methyl, Hydroxyl oder einen Rest der Formel IV

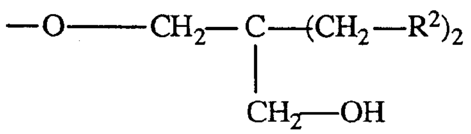

(IV)

bedeutet und $R^2$ einen Rest der Formel V

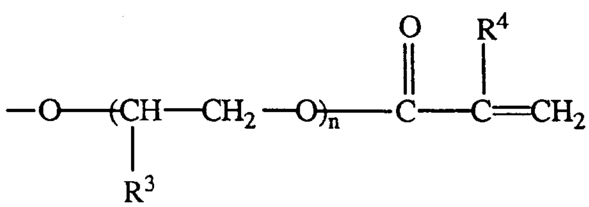

(V)

bedeutet, worin n für Null oder eine Zahl von 1-3 steht und $R^3$ und $R^4$ unabhängig voneinander je ein Wasserstoffatom oder Methyl bedeuten.

**6.** Gemisch gemäss Anspruch 5, enthaltend als Komponente (b) eine Verbindung der Formel I, worin $R_1$ eine Methylgruppe oder einen Rest der Formel IV darstellt und $R^2$ einen Rest der Formel V bedeutet, worin n Null ist.

**7.** Gemisch gemäss Anspruch 1, enthaltend als Komponente (e) die Di(meth)acrylate von ethoxyliertem Bisphenol A oder ethoxyliertem Bisphenol F.

**8.** Gemisch gemäss Anspruch 1, enthaltend als Photoinitiator ein $\alpha$-Hydroxyphenylketon, ein Benzildimethylketal oder 2,4,6-Trimethylbenzoyldiphenylphosphinoxid.

**9.** Verwendung eines Gemisches gemäss Anspruch 1 zur Herstellung von photopolymerisierten Schichten, insbesondere in Form von dreidimensionalen Gegenständen, die aus mehreren aneinander haftenden, verfestigten Schichten aufgebaut sind.

**10.** Verfahren zur Herstellung von dreidimensionalen Gegenständen aus einem flüssigen, photoempfindlichen Gemisch gemäss Anspruch 1 mittels stereolithographischen Verfahren, wobei die Oberfläche einer Schicht aus dem erfindungsgemässen, flüssigen Gemisch ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

**11.** Verfahren gemäss Anspruch 10, indem als Strahlenquelle eine Laserstrahl, vorzugsweise ein computergesteuerter Laserstrahl, verwendet wird.

## Claims

1. A liquid, photosensitive mixture containing
   a) 5-25 % by weight of a monomeric aliphatic or cycloaliphatic di(meth)acrylate having a molecular weight (MW) of not more than 800,
   b) 0-15 % by weight of a monomeric poly(meth)acrylate having a functionality of at least 3 and an MW of not more than 600,
   c) 0-20 % by weight of a mono(meth)acrylate or a mono-N-vinyl compound having an MW of not more than 500,
   d) 20-60 % by weight of a urethane (meth)acrylate having a functionality of 2 to 4 and an MW of 500 to 10,000,
   e) 10-50 % by weight of a monomeric or oligomeric di(meth)acrylate based on bisphenol A or bisphenol F,
   f) 0.1-10 % by weight of a photoinitiator and
   g) 0-5 % by weight of customary additives,
   the proportion of the components a) to g) together being 100 % by weight.

2. A mixture according to claim 1, containing
   a) 5-15 % by weight of a monomeric aliphatic or cycloaliphatic di(meth)acrylate,
   b) 5-10 % by weight of a monomeric poly(meth)acrylate,
   c) 1-15 % by weight of a mono(meth)acrylate,
   d) 30-50 % by weight of a urethane (meth)acrylate,
   e) 30-50 % by weight of a di(meth)acrylate based on bisphenol A or bisphenol F,
   f) 0.5-7 % by weight of a photoinitiator and
   g) 0.01-3 % by weight of an additive.

3. A mixture according to claim 1, in which the MW of the component (a) is 200-500, of the component (b) is 250-500, of the component (c) is 50-300, of the component (d) is 500-7000 and of the component (e) is 300-1000.

4. A mixture according to claim 1, containing aliphatic di(meth)acrylates as the component (a).

5. A mixture according to claim 1, containing, as the component (b), a tri-, tetra- or penta-acrylate or tri-, tetra- or penta-methacrylate of the formula I, II or III

$$R^1\text{-}CH_2\text{-}C(CH_2\text{-}R^2)_3 \qquad (I),$$

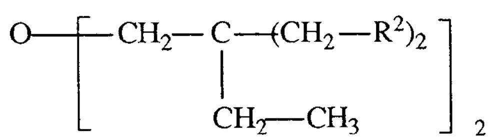

(II)

or

$$R^2\text{-}CH(CH_2\text{-}R^2)_2 \qquad (III),$$

in which $R^1$ is a hydrogen atom, methyl, hydroxyl or a radical of the formula IV

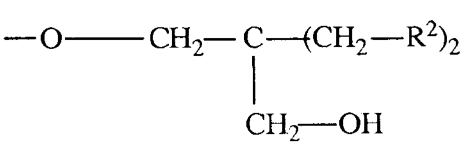

(IV)

and $R^2$ is a radical of the formula V

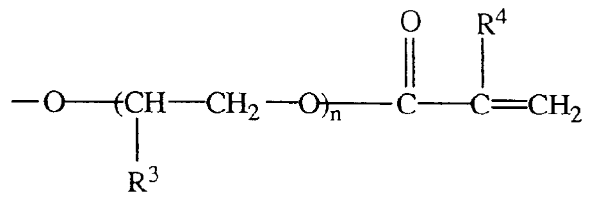 (V)

in which n is zero or a number from 1 to 3 and $R^3$ and $R^4$ independently of one another are each a hydrogen atom or methyl.

6. A mixture according to claim 5, containing, as the component (b), a compound of the formula I in which $R^1$ is a methyl group or a radical of the formula IV and $R^2$ is a radical of the formula V in which n is zero.

7. A mixture according to claim 1, containing, as the component (e), the di(meth)acrylates of ethoxylated bisphenol A or of ethoxylated bisphenol F.

8. A mixture according to claim 1, containing, as the photoinitiator, an $\alpha$-hydroxyphenyl ketone, a benzil dimethyl ketal or 2,4,6-trimethylbenzoyldiphenylphosphine oxide.

9. The use of a mixture according to claim 1 for the production of photopolymerized layers, particularly in the form of three-dimensional articles built up from several solidified layers adhering to one another.

10. A process for the production of three-dimensional articles from a liquid, photosensitive mixture according to claim 1 by means of stereolithographic processes in which the surface of a layer of the liquid mixture according to the invention is irradiated either as the whole surface or in a predetermined pattern, by means of a UV/VIS light source, so that a layer is solidified in a desired layer thickness in the irradiated areas, then a new layer of the mixtures according to the invention is formed on the solidified layer, and this is also irradiated either as the whole surface or in a predetermined pattern, and, by repeated coating and irradiation, three-dimensional articles composed of several solidified layers adhering to one another are obtained.

11. A process according to claim 10, in which the radiation source used is a laser beam, preferably a computer-controlled laser beam.

## Revendications

1. Mélange photosensible, liquide, contenant
   a) de 5 à 25 % en poids d'un di(méth)acrylate monomère, aliphatique ou cycloaliphatique, ayant un poids moléculaire au maximum de 800,
   b) de 0 à 15 % en poids d'un poly(méth)acrylate monomère ayant une fonctionnalité d'au moins 3 et un poids moléculaire au maximum de 600,
   c) de 0 à 20 % en poids d'un mono(méth)acrylate ou d'un composé mono-N-vinylique ayant un poids moléculaire au maximum de 500,
   d) de 20 à 60 % en poids d'un uréthanne-(méth)acrylate ayant une fonctionnalité allant de 2 à 4 et un poids moléculaire allant de 500 à 10.000,
   e) de 10 à 50 % en poids d'un di(méth)acrylate monomère ou oligomère à base de bisphénol A ou de bisphénol F,
   f) de 0,1 à 10 % en poids d'un photoinitiateur, et
   g) de 0 à 5 % en poids d'additifs classiques,
   les compositions des composants a) à g) représentant ensemble 100 % en poids.

2. Mélange selon la revendication 1, contenant
   a) de 5 à 15 % en poids d'un di(méth)acrylate monomère, aliphatique ou cycloaliphatique,
   b) de 5 à 10 % en poids d'un poly(méth)acrylate monomère,
   c) de 1 à 15 % en poids d'un mono(méth)acrylate,
   d) de 30 à 50 % en poids d'un uréthanne-(méth)acrylate,
   e) de 30 à 50 % en poids d'un di(méth)acrylate à base de bisphénol A et de bisphénol F,

f) de 0,5 à 7 % en poids d'un photoinitiateur et
g) de 0,01 à 3 % en poids d'un additif.

3. Mélange selon la revendication 1, dans lequel le poids moléculaire du composant (a) est compris entre 200 et 500, celui du composant (b) est compris entre 250 et 500, celui du composant (c) est compris entre 50 et 300, celui du composant (d) est compris entre 500 et 7000 et celui du composant (e) est compris entre 300 et 1000.

4. Mélange selon la revendication 1, contenant comme composant (a) des di(méth)acrylates aliphatiques.

5. Mélange selon la revendication 1, contenant en tant que composant (b) un tri-, tétra- ou penta-acrylate ou - méthacrylate de formule I, II ou III

$R^1$-$CH_2$-C-($CH_2$-$R^2$)$_3$ (I),

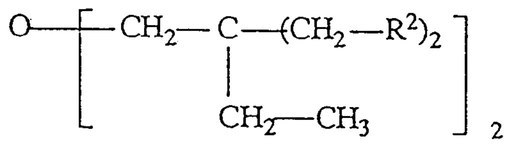

(II)

ou

$R^2$-CH-($CH_2$-$R^2$)$_2$ (III),

dans lesquelles $R^1$ signifie un atome d'hydrogène, un méthyle, un hydroxyle ou un reste de formule IV

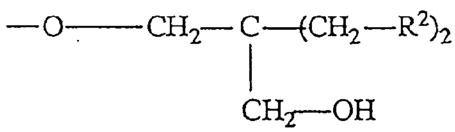

(IV)

et $R^2$ signifie un reste de formule V

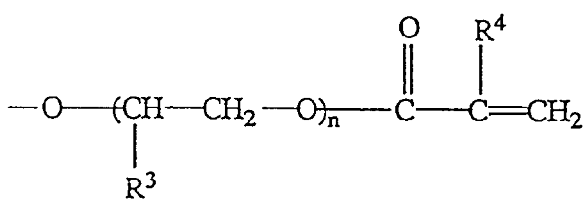

(V)

dans laquelle n vaut 0 ou représente un chiffre allant de 1 à 3 et $R^3$ et $R^4$ signifie, indépendamment l'un de l'autre, chacun un atome d'hydrogène ou un méthyle.

6. Mélange selon la revendication 5, contenant en tant que composant (b) un composé de formule I, dans laquelle $R^1$ représente un groupe méthyle ou bien un reste de formule IV et $R^2$ signifie un reste de formule V, dans laquelle n vaut zéro.

7. Mélange selon la revendication 1, contenant en tant que composant (e) les di(méth)acrylates de bisphénol A éthoxylé ou de bisphénol F éthoxylé.

8. Mélange selon la revendication 1, contenant en tant que photoinitiateur une α-hydroxyphenylcetone, un benzildiméthylcétal ou le 2,4,6-triméthylbenzoyldiphénylphosphinoxyde.

9. Utilisation d'un mélange selon la revendication 1, pour la préparation de couches photopolymérisées, en particulier dans la forme d'objets tridimensionnels, qui sont construits de plusieurs couches durcies adhérentes les unes aux autres.

10. Procédé de préparation d'objets tridimensionnels à partir d'un mélange liquide photosensible selon la revendication 1, au moyen d'un procédé stéréolithographique, la surface d'une couche constituée du mélange liquide conforme à l'invention étant irradiée sur toute la surface ou bien selon un modèle prédéterminé avec une source de lumière UV/VIS de sorte qu'on prépare dans le domaine irradié une couche dans une épaisseur de couche désirée, après quoi on forme une nouvelle couche constituée des mélanges conformes à l'invention sur la couche durcie, qui est irradiée également sur toute la surface ou bien selon un modèle prédéterminé, et en obtenant par enduction et irradiation répétées des objets tridimensionnels constitués de plusieurs couches durcies adhérentes l'une à l'autre.

**11.** Procédé selon la revendication 10, dans lequel on utilise comme source de rayonnement un rayon laser, de préférence un rayon laser assisté par ordinateur.